# FASCICULE DE BREVET EUROPEEN

(11) **EP 1 839 341 B1**
(45) Date de publication et mention de la délivrance du brevet: **11.01.2017**
(21) Numéro de dépôt: 06709408.6
(22) Date de dépôt: 18.01.2006
(51) Int. Cl.: H01L 31/0352, H01L 27/142, H01L 31/20

(54) **DISPOSITIF SEMI-CONDUCTEUR A HETEROJONCTIONS ET A STRUCTURE INTER-DIGITEE**
HALBLEITERBAUELEMENT MIT HETEROÜBERGÄNGEN UND VERZAHNTER STRUKTUR
SEMICONDUCTOR DEVICE WITH HETEROJUNCTIONS AND AN INTER-FINGER STRUCTURE

(30) Priorité: 20.01.2005 FR 0550174
(43) Date de publication de la demande: 03.10.2007
(60) Demande divisionnaire: 09156836.0
(73) Titulaire: Commissariat à l'Énergie Atomique et aux Énergies Alternatives, 75015 Paris (FR)
(72) Inventeur: RIBEYRON, Pierre Jean, F-38330 Saint Ismier (FR); JAUSSAUD, Claude, 38240 Meylan (FR)
(74) Mandataire: Ahner, Philippe
(86) Numéro de dépôt international: PCT/FR2006/050021
(87) Numéro de publication internationale: WO 2006/077343

(56) Documents cités:
- WO-A-03/083955
- US-B1- 6 274 402
- PATENT ABSTRACTS OF JAPAN vol. 015, no. 405 (E-1122), 16 octobre 1991 (1991-10-16) & JP 03 165578 A (HITACHI LTD), 17 juillet 1991 (1991-07-17)
- VERLINDEN P ET AL COMMISSION OF THE EUROPEAN COMMUNITIES: "MULTILEVEL METALLIZATION FOR LARGE AREA POINT-CONTACT SOLAR CELLS" PROCEEDINGS OF THE INTERNATIONAL PHOTOVOLTAIC ENERGY CONFERENCE. FLORENCE, MAY 9 - 13, 1988, DORDRECHT, KLUWER, NL, vol. VOL. 2 CONF. 8, 9 mai 1988 (1988-05-09), pages 1466-1471, XP000044541

## Description

### DOMAINE TECHNIQUE

La présente invention se rapporte à un dispositif semi-conducteur à hétérojonctions et à structure inter-digitée placée sur une couche semi-conductrice du dispositif, et au procédé pour sa fabrication. Un tel dispositif peut être, par exemple, une cellule solaire possédant une structure inter-digitée intégrant des hétérojonctions, et le procédé convient particulièrement à la réalisation de ce type de cellules solaires, sur silicium en couche mince.

### ÉTAT DE LA TECHNIQUE ANTÉRIEURE

Actuellement, plusieurs types de technologie sont utilisés pour la réalisation de dispositifs à semi-conducteurs. Dans la fabrication des cellules solaires, deux types de technologie sont principalement utilisés : les cellules à homojonctions, et les cellules à hétérojonctions.

Dans le brevet US 4 234 352, une cellule solaire à homojonctions et à structure inter-digitée y est décrite. Cette cellule comporte un substrat en silicium cristallin. Ce substrat comprend deux faces opposées. L'une des faces, dite face avant, est destinée à recevoir la lumière, alors que l'autre face comporte une pluralité de régions dopées N ou P. Ces régions sont placées de manière à avoir des alignements inter-digités de régions identiquement dopées. Les brevets US 6 333 457 et US 6 452 090 décrivent également des cellules solaires à homojonctions de structure identique.

Une méthode de fabrication de surface de points de contact pour une cellule solaire à structure inter-digitée et à homojonctions est exposée dans le brevet US 4 927 770.

Un dispositif semi-conducteur utilisant une structure inter-digitée à homojonctions est également décrit dans le brevet US 6 426 235. Ce dispositif comporte un substrat de silicium cristallin d'un premier type de conductivité sur lequel sont fabriquées une couche de silicium cristallin dopée du premier type de conductivité, et une couche de silicium cristallin dopée d'un second type de conductivité opposé au premier type de conductivité empilées. L'une des deux couches est ensuite gravée de manière à former une structure inter-digitée pouvant recevoir des électrodes.

La demande de brevet EP-A2-0 776 051 décrit une cellule solaire présentant une géométrie similaire. Un substrat de silicium d'un premier type de conductivité comporte deux faces principales opposées dopées du premier type de conductivité. Des contacts ohmiques en aluminium sont disposés sur une de ces faces selon une structure inter-digitée, deux contacts voisins étant séparés par une distance environ égale à leur largeur. Un dopage d'un second type de conductivité opposé au premier type de conductivité est alors réalisé sur ces contacts ohmiques.

La demande de brevet français FR 2 854 497 décrit un procédé de réalisation d'un dispositif semi-conducteur à métallisations auto-alignées. Le dispositif comprend un substrat de silicium cristallin. Ce substrat comporte deux faces principales opposées. Un dopage d'un premier type de conductivité est réalisé sur une de ces faces. Des fenêtres sont ensuite gravées sur cette face. La gravure réalisée étant plus profonde que l'épaisseur du dopage, les fenêtres permettent de réaliser des dopages d'un second type de conductivité opposé au premier type de conductivité dans les zones du substrat ainsi découvertes. Des métallisations viennent ensuite en contact avec ces régions dopées. Là encore, on obtient une structure inter-digitée à homojonctions.

Toutes les cellules citées précédemment utilisent une structure inter-digitée à homojonctions. L'inconvénient majeur de ce type de structure, notamment pour la réalisation de cellules solaires, est le fort budget thermique utilisé pendant le procédé de fabrication. Donc, pour réaliser de bonnes cellules inter-digitées à homojonctions, il est nécessaire d'avoir des matériaux semi-conducteurs possédant une bonne durée de vie, et qui la conserve tout au long du procédé de fabrication. Or, ce type de matériau est le plus souvent très cher et donc peu compatible avec l'obtention de cellules solaires à bas coût. Compte tenu du fort budget thermique utilisé, l'utilisation de pâtes de sérigraphie dites « haute température » est également nécessaire.

De plus, la structure inter-digitée est d'autant plus efficace que l'épaisseur du semi-conducteur est faible. Or, utiliser un procédé de fabrication utilisant un fort budget thermique induit un grand stress thermique dans le matériau, et donc augmente le risque de détérioration lors du procédé de fabrication.

Le principe de l'hétérojonction amorphe / cristallin est déjà connu. Des cellules solaires reprenant ce principe ont déjà été brevetées.

Le principe de ce type de cellule est d'utiliser un substrat de semi-conducteur cristallin dopé d'un premier type de conductivité. Sur une de ses faces, un semi-conducteur amorphe dopé d'un second type de conductivité opposé au premier type de conductivité, vient alors en contact. On obtient alors une jonction PN appelée hétérojonction, car les deux semi-conducteurs utilisés sont de composition atomique différente et n'ont pas la même largeur de bande interdite. Il suffit alors de réaliser une électrode transparente sur une première face de la jonction et, sur une seconde face opposée à cette première face, de réaliser une électrode de contact ohmique pour obtenir une cellule solaire à hétérojonction.

Par rapport aux cellules à homojonctions, il y a tout d'abord un avantage de coût car le procédé de fabrication est réalisé à basse température. Cela permet d'éviter les inconvénients décrits précédemment apparaissant lors des procédés à haute température. Cette technologie permet également de fabriquer des cellules plus fines sans risque de stress thermique, et donc de détérioration. Enfin, lorsque les semi-conducteurs utilisés sont du silicium, cette structure à hétérojonction permet d'utiliser une variété plus large de silicium cristallin car il n'y a pas de dégradation de la durée de vie liée aux traitements thermiques à haute température.

Le brevet US 5 066 340 décrit une cellule solaire à hétérojonction. Celle-ci comporte une jonction PN formée par un substrat de silicium cristallin d'un premier type de conductivité et une couche de silicium amorphe d'un second type de conductivité, opposé au premier type de conductivité, réalisée sur une des faces du substrat cristallin. Cette cellule intègre également, entre le substrat cristallin et la couche de silicium amorphe, une couche de silicium microcristallin intrinsèque.

Le brevet US 5 213 628 décrit également une cellule solaire à hétérojonction. Comme dans le brevet US 5 066 340, cette cellule comporte une hétérojonction formée par un substrat de silicium cristallin d'un premier type de conductivité et une couche de silicium amorphe d'un second type de conductivité, opposé au premier type de conductivité, réalisée sur une des faces du substrat cristallin. Cette cellule intègre, entre le substrat cristallin et la couche de silicium amorphe, une couche de silicium amorphe intrinsèque.

L'inconvénient majeur de ces cellules à hétérojonction est de n'avoir qu'une seule structure de connexion possible : une électrode du côté du silicium amorphe et une électrode du côté du silicium cristallin.

Le document WO 03/083955 décrit un dispositif semi-conducteur comportant, sur une face d'un substrat semi-conducteur cristallin, une première région de semi-conducteur amorphe dopée N et une seconde région de semi-conducteur amorphe dopée P. La première région de semi-conducteur amorphe et la seconde région de semi-conducteur amorphe forment une structure inter-digitée. Une couche semi-conductrice intrinsèque est disposée entre le substrat et les régions de semi-conducteur amorphe pour réaliser la passivation de la surface du substrat. Une couche isolante en résine de polyimide est disposée entre les régions de semi-conducteur amorphe, sur la couche semi-conductrice intrinsèque, permettant de réaliser l'isolation électrique entre les régions de semi-conducteur amorphe. Dans ce dispositif, l'isolation électrique et la passivation de surface nécessitent deux couches différentes car le matériau de la couche isolante n'est compatible avec un rôle de passivation de surface.

### EXPOSÉ DE L'INVENTION

La présente invention a pour but de proposer un dispositif semi-conducteur à hétérojonctions qui ne présente pas l'inconvénient mentionné ci-dessus, à savoir être limité par une structure de connexion comprenant une électrode sur deux faces principales opposées du dispositif, et qui propose une structure plus simple et mieux isolée électriquement que les dispositifs semi-conducteur à structure inter-digitée existants.

Pour atteindre ces buts, la présente invention propose un dispositif semi-conducteur, comportant sur au moins une face d'un substrat semi-conducteur cristallin, au moins une première région de semi-conducteur amorphe dopée par un premier type de conductivité, le substrat semi-conducteur comportant sur la même face au moins une seconde région de semi-conducteur amorphe dopée d'un second type de conductivité, opposé au premier type de conductivité, la première région de semi-conducteur amorphe, isolée de la seconde région de semi-conducteur amorphe par au moins une région diélectrique en contact avec le substrat semi-conducteur, et la seconde région de semi-conducteur amorphe formant une structure inter-digitée.

Ainsi, au lieu d'utiliser un dispositif semi-conducteur à hétérojonctions ne présentant pas les avantages d'une structure inter-digitée, on utilise un dispositif semi-conducteur à hétérojonctions et à structure inter-digitée, cumulant à la fois les avantages d'une structure à hétérojonctions par rapport à une structure à homojonctions, et les avantages d'une structure inter-digitée, jusqu'alors utilisée uniquement dans des dispositifs semi-conducteur à homojonctions.

De plus, les régions de diélectrique entre les régions amorphes s'étendent jusqu'au substrat, assurant à la fois l'isolation électrique entre les régions amorphes et la passivation de la surface du substrat, offrant une structure plus simple et une meilleure isolation électrique entre les régions de semi-conducteur amorphe par rapport aux dispositifs existants.

Les régions de diélectrique peuvent être de l'oxyde de silicium, ou du nitrure de silicium.

Il est préférable qu'au moins une première zone de métallisation soit en contact avec la première région de semi-conducteur amorphe et qu'au moins une seconde zone de métallisation soit en contact avec la seconde région de semi-conducteur amorphe, afin de pouvoir connecter le dispositif à un environnement extérieur.

On peut également envisager qu'au moins une première zone d'oxyde thermique conducteur se trouve entre la première zone de métallisation et la première région de semi-conducteur amorphe et en ce qu'au moins une seconde zone d'oxyde thermique conducteur se trouve entre la seconde zone de métallisation et la seconde région de semi-conducteur amorphe. Ces zones d'oxyde thermique conducteur permettent d'assurer une meilleure résistivité de contact entre les zones de métallisation et les régions de semi-conducteur amorphe.

Dans ce cas, les zones d'oxyde thermique conducteur peuvent être en oxyde d'étain et d'indium ou en oxyde de zinc.

Les zones de métallisation peuvent être réalisées à base d'un métal noble tel que l'argent, ou à base d'aluminium.

Le substrat semi-conducteur peut comporter sur une autre face, opposée à la face ayant la structure inter-digitée, une couche de passivation de surface recouverte d'une couche antiréflective. La couche de passivation de surface permet de repousser les porteurs de charge et la couche antiréflective permet de piéger au maximum les photons qui entrent dans le dispositif.

La couche de passivation de surface peut être en semi-conducteur amorphe du premier type de conductivité, du second type de conductivité ou intrinsèque.

Il est alors préférable que la couche de passivation de surface soit du silicium.

La couche antiréflective peut être en nitrure de silicium.

On peut envisager que la première et/ou la seconde région de semi-conducteur amorphe soient dopées graduellement, de manière à assurer un bon état d'interface avec le substrat semi-conducteur.

Il est également préférable que le substrat semi-conducteur soit en silicium monocristallin ou en silicium polycristallin, suivant le type de dispositif désiré.

Les régions de semi-conducteur amorphe peuvent être en silicium. C'est le matériau le plus utilisé actuellement pour la réalisation de dispositif semi-conducteur à hétérojonctions.

Le substrat semi-conducteur peut être d'un certain type de conductivité.

Le substrat semi-conducteur est de préférence un substrat en couche mince.

Des régions de semi-conducteur intrinsèque peuvent être disposées entre les régions de semi-conducteur amorphe et le substrat, permettant d'assurer un bon état d'interface avec le substrat en évitant les recombinaisons au niveau du substrat.

Un tel dispositif peut être avantageusement une cellule solaire.

Plusieurs cellules solaires peuvent être regroupées pour former un module, ces cellules étant connectées en série et/ou parallèle.

La présente invention concerne également un procédé de réalisation d'un dispositif semi-conducteur tel que revendiqué à la revendication 1 comportant les étapes suivantes :
a) réalisation sur une face d'un substrat semi-conducteur d'une première couche isolante,
b) gravure dans la première couche isolante d'au moins une première fenêtre mettant à nu une partie du substrat semi-conducteur,
c) dépôt d'une première couche de semi-conducteur amorphe dopé d'un premier type de conductivité sur la première couche isolante et dans la première fenêtre,
d) gravure dans la première couche de semi-conducteur amorphe et la première couche isolante d'au moins une seconde fenêtre, décalée par rapport à la première fenêtre, mettant à nu une partie du substrat semi-conducteur,
e) réalisation d'une seconde couche isolante dans la seconde fenêtre et sur la première couche de semi-conducteur amorphe,
f) gravure d'au moins une première ouverture dans la seconde couche isolante, au niveau de la seconde fenêtre, mettant à nu une partie du substrat semi-conducteur,
g) dépôt d'une seconde couche de semi-conducteur amorphe dopé d'un second type de conductivité opposé au premier type de conductivité, dans la première ouverture, et sur la seconde couche isolante,
la première couche de semi-conducteur amorphe et la seconde couche de semi-conducteur amorphe formant une structure inter-digitée ayant un contour délimité lors de la gravure de la première fenêtre et de la première ouverture.

Le procédé peut comporter entre l'étape b) et l'étape c), une étape de dépôt d'au moins une première région de semi-conducteur intrinsèque au moins dans la première fenêtre et/ou, entre l'étape f) et l'étape g), une étape de dépôt d'au moins une seconde région de semi-conducteur intrinsèque au moins dans la première ouverture.

Le procédé peut comporter entre l'étape c) et l'étape d), ou entre l'étape d) et l'étape e), une étape de dépôt d'au moins une première zone de métallisation sur la première couche de semi-conducteur amorphe.

Dans une autre variante, le procédé peut comporter entre l'étape c) et l'étape d), ou entre l'étape d) et l'étape e), une étape de dépôt d'au moins une première zone d'oxyde thermique conducteur sur la première couche de semi-conducteur amorphe, puis une étape de dépôt d'au moins une première zone de métallisation sur la première zone d'oxyde thermique conducteur.

La première zone de métallisation est de préférence centrée au-dessus de la première fenêtre.

Il est également préférable que la taille de la première zone de métallisation soit inférieure à celle de la première fenêtre.

Le procédé peut comporter après l'étape g) une étape de gravure d'au moins une seconde ouverture dans la seconde couche de semi-conducteur amorphe et dans la seconde couche isolante, au-dessus de la première zone de métallisation, dont la taille est inférieure ou égale à celle de la première zone de métallisation, mettant à nu au moins une partie de la première zone de métallisation.

Le procédé peut également comporter après l'étape g) une étape de dépôt d'au moins une seconde zone de métallisation sur la seconde couche de semi-conducteur amorphe, au niveau de la seconde fenêtre, sur au moins la première ouverture.

Dans une autre variante, le procédé peut comporter après l'étape g) une étape de dépôt d'au moins une seconde zone d'oxyde thermique conducteur sur la seconde couche de semi-conducteur amorphe, au niveau de la seconde fenêtre, sur au moins la première ouverture, puis une étape de dépôt d'au moins une seconde zone de métallisation sur la seconde zone d'oxyde thermique conducteur.

Il est préférable que la première ouverture ait une taille inférieure à celle de la seconde fenêtre.

La présente invention concerne également un procédé de réalisation d'un dispositif semi-conducteur tel que revendiqué à la revendication 1 comportant les étapes suivantes :
a) dépôt sur une face d'un substrat semi-conducteur d'au moins une première couche de semi-conducteur amorphe dopé d'un premier type de conductivité,
b) dépôt d'au moins une première zone de métallisation sur au moins la première couche de semi-conducteur amorphe,
c) élimination de zones de la première couche de semi-conducteur amorphe non recouvertes par la première zone de métallisation,
d) dépôt d'au moins une seconde couche de semi-conducteur amorphe dopé d'un second type de conductivité opposé au premier type de conductivité sur au moins la face du substrat,
e) dépôt d'au moins une seconde zone de métallisation sur au moins la seconde couche de semi-conducteur amorphe,
f) élimination de zones de la seconde couche de semi-conducteur amorphe non recouvertes par la seconde zone de métallisation,
g) dépôt d'une couche isolante diélectrique sur au moins la face (3) du substrat, assurant également la pasivation de la face (3) du substrat,
   la première couche de semi-conducteur amorphe et la seconde couche de semi-conducteur amorphe formant une structure inter-digitée.

Ainsi, on utilise les zones de métallisation comme masque pour réaliser la gravure des couches de semi-conducteur amorphe. Ce procédé est simple et peu coûteux à mettre en oeuvre car les étapes de gravure ne nécessitent qu'un simple alignement par rapport aux zones de métallisation pour être mises en oeuvre.

Le procédé peut comporter après l'étape f), une étape de dépôt d'une couche isolante sur au moins la face du substrat.

La couche isolante peut être une couche de diélectrique.

Le procédé peut comporter après l'étape de dépôt de la couche isolante une étape de réalisation d'ouvertures dans la couche isolante au niveau des zones de métallisation afin de rendre accessibles les métallisations pour des contacts extérieurs.

Le procédé peut comporter avant l'étape a) une étape de dépôt d'au moins une couche de semi-conducteur intrinsèque sur la face du substrat, la première couche de semi-conducteur amorphe étant alors déposée sur la couche de semi-conducteur intrinsèque et l'étape c) réalisant également l'élimination de zones de la couche de semi-conducteur intrinsèque non recouvertes par la première zone de métallisation.

Le procédé peut également comporter entre l'étape c) et l'étape d) une étape de dépôt d'au moins une seconde couche de semi-conducteur intrinsèque sur au moins la face du substrat, la seconde couche de semi-conducteur amorphe étant alors déposée sur la seconde couche de semi-conducteur intrinsèque et l'étape f) réalisant également l'élimination de zones de la seconde couche de semi-conducteur intrinsèque non recouvertes par la seconde zone de métallisation.

Au moins l'une des étapes c) et/ou f) d'élimination de zones de semi-conducteur peut être réalisée par gravure.

Le procédé peut comporter les étapes suivantes :
- dépôt sur une autre face, opposée à la face ayant la structure inter-digitée, du substrat semi-conducteur d'une couche de passivation de surface,
- dépôt sur la couche de passivation de surface d'une couche antiréflective.

Ces deux étapes sont de préférence réalisées avant l'étape a).

Au moins une gravure peut être réalisée par laser ou par sérigraphie de pâtes gravantes.

Au moins une gravure peut être une gravure sélective permettant de graver le semi-conducteur amorphe et non le métal.

Le substrat est de préférence, avant l'étape a), préalablement décapé avec un nettoyage RCA classique (technique de nettoyage développée par la société RCA) et un nettoyage à l'acide fluorhydrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1A représente en coupe un dispositif semi-conducteur selon l'invention,
- la figure 1B représente une vue de dessous d'un dispositif semi-conducteur selon l'invention,
- la figure 1C représente en coupe un dispositif semi-conducteur selon l'invention,
- les figures 2, 3, 4A, 4B et 4C illustrent différentes étapes d'un procédé selon l'invention pour la réalisation d'un dispositif semi-conducteur selon l'invention,
- les figures 5, 6, 7A et 7B illustrent différentes étapes d'un procédé selon l'invention pour la réalisation d'un dispositif semi-conducteur selon l'invention,

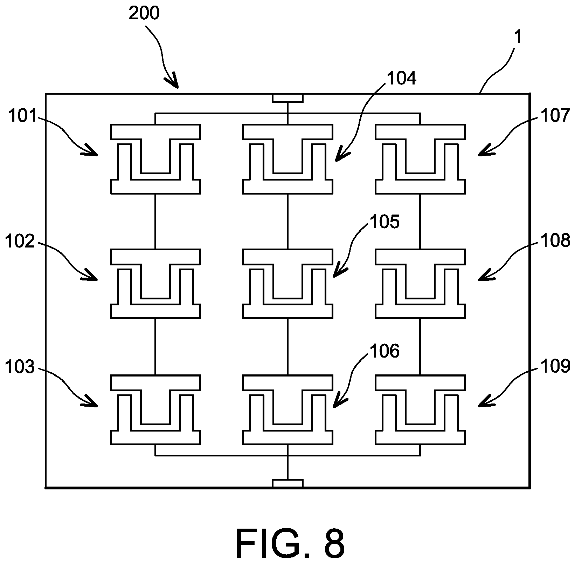

- la figure 8 représente une vue de dessous d'un module formé de plusieurs cellules solaires reliées entre elles, également objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

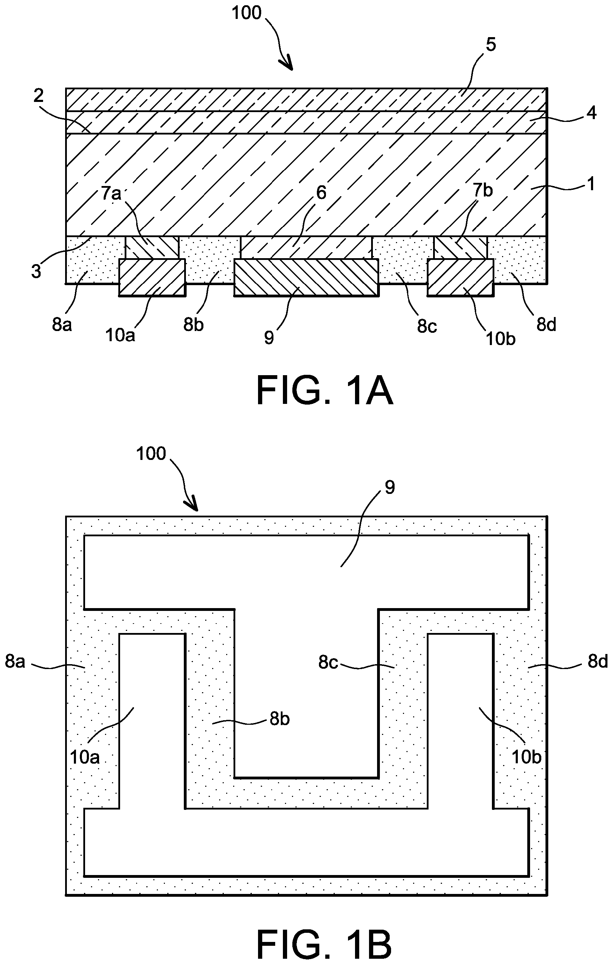

On se réfère à la figure 1A qui montre en coupe un exemple de dispositif semi-conducteur 100 à hétérojonctions et à structure inter-digitée, objet de la présente invention. Le dispositif semi-conducteur 100 comporte, sur au moins une face 3 d'un substrat semi-conducteur 1 cristallin, au moins une première région 6 de semi-conducteur amorphe. Cette première région 6 est dopée d'un premier type de conductivité. Le substrat semi-conducteur 1 comporte également sur la face 3 au moins une seconde région 7a, 7b de semi-conducteur amorphe. Cette seconde région 7a, 7b est dopée d'un second type de conductivité, opposé au premier type de conductivité. Ces régions 6, 7a, 7b de semi-conducteur amorphe forment une structure inter-digitée. Dans cet exemple, le dispositif semi-conducteur 100 une cellule solaire.

Le dispositif semi-conducteur 100 comporte le substrat semi-conducteur 1 que l'on suppose dans cet exemple en couche mince. Ce substrat semi-conducteur 1 peut être par exemple en silicium monocristallin ou polycristallin. Il n'est pas nécessaire d'utiliser un silicium de très bonne qualité car, du fait de l'absence de fortes contraintes thermiques pendant le procédé de réalisation du dispositif semi-conducteur 100, le silicium ne verra pas la durée de vie de ses porteurs de charge altérée. L'épaisseur du substrat semi-conducteur 1 en couche mince peut être comprise par exemple entre environ 10 micromètres et quelques centaines de micromètres. Le substrat semi-conducteur 1 peut être d'un certain type de conductivité. Dans l'exemple illustré de la figure 1A, le substrat semi-conducteur 1 est de type N.

Le substrat semi-conducteur 1 comporte la face 3 qui dans cet exemple est du côté de la face arrière de la cellule solaire. Le substrat semi-conducteur 1 comporte une autre face 2, opposée à la face 3, qui est du côté de la face avant de la cellule solaire. C'est la face avant de la cellule solaire qui est exposée à la lumière.

Le substrat semi-conducteur 1 comporte, sur la face 3, au moins une première région 6 de semi-conducteur amorphe dopé d'un premier type de conductivité. Dans l'exemple illustré sur la figure 1A, le substrat semi-conducteur 1 comporte sur la face 3 une seule première région 6. Cette première région 6 est par exemple du silicium amorphe dopé N. L'épaisseur de la première région 6 de semi-conducteur amorphe peut être comprise par exemple entre environ quelques nanomètres et quelques dizaines de nanomètres. La première région 6 de semi-conducteur amorphe peut être graduellement dopée (dopage le plus faible près de la face 3 du substrat 1) afin d'assurer un bon état d'interface avec le substrat semi-conducteur 1.

Le substrat semi-conducteur 1 comporte également sur la face 3, au moins une seconde région 7a, 7b de semi-conducteur amorphe dopée d'un second type de conductivité, opposé au premier type de conductivité. Dans l'exemple illustré sur la figure 1A, le substrat semi-conducteur 1 comporte sur la face 3 deux secondes régions 7a, 7b, réalisées de part et d'autres de la première région 6. On suppose que ces deux secondes régions 7a, 7b sont en silicium amorphe dopé P. L'épaisseur des secondes régions 7a, 7b de semi-conducteur amorphe peut être comprise par exemple entre environ quelques nanomètres et quelques dizaines de nanomètres. Les secondes régions 7a, 7b de semi-conducteur amorphe peuvent être graduellement dopées (dopage le plus faible près de la face 3 du substrat 1) afin d'assurer un bon état d'interface avec le substrat semi-conducteur 1. L'épaisseur de la première région 6 peut être différente de l'épaisseur des secondes régions 7a, 7b.

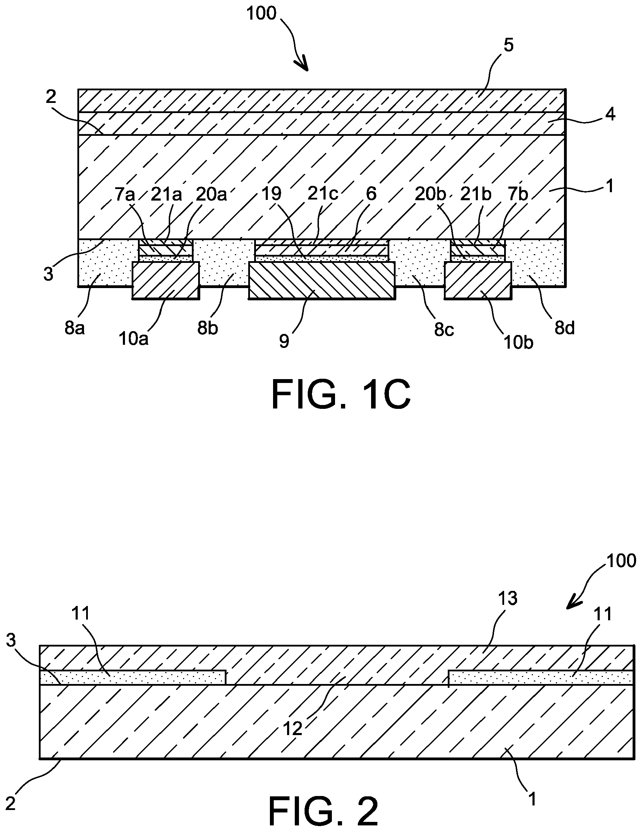

Des régions de semi-conducteur intrinsèque 21a, 21b, 21c peuvent être disposées entre les régions de semi-conducteur amorphe 6, 7a, 7b et la face 3 du substrat 1, comme cela est représenté sur la figure 1C. Ces régions 21a, 21b, 21c permettent d'assurer un bon état d'interface avec le substrat 1 en évitant les recombinaisons au niveau de la face 3 du substrat 1.

Intercalées entre les régions 6, 7a, 7b de semi-conducteur amorphe se trouvent des régions de diélectrique 8a, 8b, 8c, 8d. Ces régions de diélectrique 8a, 8b, 8c, 8d ont un rôle d'isolation entre deux régions de semi-conducteur amorphe ayant des types de conductivité différents. Elles permettent de ne pas provoquer de court-circuit entre ces deux régions. Ces régions isolantes 8a, 8b, 8c, 8d peuvent être par exemple de l'oxyde de silicium, du nitrure de silicium ou du silicium cristallin amorphe. Dans l'exemple illustré sur la figure 1A, l'épaisseur des régions isolantes 8a, 8b, 8c, 8d est supérieure à l'épaisseur des régions 6, 7a, 7b de semi-conducteur amorphe. Ces régions de diélectrique 8a, 8b, 8c, 8d s'étendent jusqu'au substrat 1, assurant à la fois l'isolation électrique entre les régions 6, 7a et 7b et la passivation de la surface 3 du substrat 1.

La première région 6 de semi-conducteur amorphe est connectée à au moins une première zone de métallisation 9. Cette zone de métallisation 9 est une première électrode de connexion pour le dispositif semi-conducteur 100. La première zone de métallisation 9 recouvre au moins partiellement la première région 6 de semi-conducteur amorphe.

De même, les secondes régions 7a, 7b de semi-conducteur amorphe sont connectées à au moins une seconde zone de métallisation 10a, 10b. Dans l'exemple illustré sur la figure 1A, deux secondes zones de métallisation 10a, 10b sont connectées respectivement aux deux secondes région 7a, 7b, et les recouvrent au moins partiellement. Reliées ensemble, les secondes zones de métallisation 10a, 10b forment la deuxième électrode de connexion du dispositif semi-conducteur 100.

Afin d'assurer une meilleure résistivité de contact entre les zones de métallisation 9, 10a, 10b et les régions de semi-conducteur amorphe 6, 7a, 7b, des zones d'oxyde thermique conducteur 19, 20a, 20b peuvent être intercalées entre les zones de métallisation 9, 10a, 10b et les régions de semi-conducteur amorphe 6, 7a, 7b. Sur la figure 1C, une première zone d'oxyde thermique conducteur 19 se trouve entre la première zone de métallisation 9 et la première région 6 de semi-conducteur amorphe. Respectivement, deux secondes zones d'oxyde thermique conducteur 20a, 20b se trouvent entre les secondes zones de métallisation 10a, 10b et les secondes régions 7a, 7b de semi-conducteur amorphe. Ces zones d'oxyde thermique conducteur 19, 20a, 20b peuvent par exemple être réalisées en oxyde d'étain et d'indium ou en oxyde de zinc.

Chacune des zones de métallisation 9, 10a, 10b peut également être en contact avec les régions isolantes 8a, 8b, 8c, 8d adjacentes aux régions 6, 7a, 7b de silicium amorphe. La première zone de métallisation 9 ne doit pas être en contact avec les secondes zones de métallisation 10a, 10b car cela entraînerait un court-circuit entre les régions 6, 7a, 7b dopées de conductivité différentes.

Les zones de métallisation 9, 10a, 10b peuvent être réalisées à base d'un métal noble, tel que l'argent, ou à base d'aluminium.

Le substrat semi-conducteur 1 comporte sur une autre face 2, opposée à la face 3, une couche de passivation de surface 4. Cette couche de passivation de surface 4 permet de repousser les porteurs de charges vers la face 3 du substrat semi-conducteur 1. Cette couche de passivation de surface 4 peut être par exemple en silicium amorphe intrinsèque, ou bien en silicium amorphe dopé d'un certain type de conductivité. La technologie à hétérojonction permet d'utiliser des couches de passivations de surface très fines, particulièrement adaptées au silicium mince.

La couche de passivation de surface 4 est recouverte d'une couche antiréflective 5. Cette couche antiréflective 5 permet à une quantité maximale de photons de pénétrer dans le substrat semi-conducteur 1, et de ne pas les laisser sortir. La couche antiréflective 5 peut être par exemple en nitrure de silicium ou en d'autres matériaux classiquement utilisés pour cette fonction comme le fluorure de magnésium ou le sulfure de zinc.

Comme on peut le voir sur la figure 1B, les zones de métallisation 9, 10a, 10b forment chacune un doigt. Les régions isolantes 8a, 8b, 8c, 8d séparent les secondes zones de métallisation 10a, 10b de la première zone de métallisation 9. La structure ainsi formée est bien une structure inter-digitée. La première zone de métallisation 9 forme une première électrode, et les secondes zones de métallisation 10a, 10b, qui sont reliées entre elles, forment une seconde électrode.

On va maintenant s'intéresser à un premier procédé de réalisation d'un autre exemple de dispositif semi-conducteur 100, également objet de la présente invention. On suppose que le dispositif semi-conducteur 100 ainsi réalisé est une cellule solaire.

Comme on peut le voir sur la figure 2, on part d'un substrat semi-conducteur 1, par exemple en silicium de type N, que l'on suppose dans cet exemple en couche mince. Les faces du substrat semi-conducteur 1 seront identifiées par une face 3 et une autre face 2, opposée à la face 3.

Avant de procéder à la réalisation de la cellule solaire 100, le substrat semi-conducteur 1 est tout d'abord décapé sur ses faces 2 et 3. Un nettoyage RCA classique et un nettoyage à l'acide fluorhydrique sont par exemple préférables pour éviter toute contamination métallique suite à la texturation et pour la préparation des surfaces du substrat semi-conducteur 1 avant tout dépôt. Le nettoyage RCA classique consiste à utiliser un premier bain de nettoyage à base d'eau déionisée, d'ammoniaque et d'eau oxygénée, et un deuxième bain de nettoyage à base d'eau déionisée, d'acide chlorhydrique et d'eau oxygénée. L'autre face 2 peut être traitée en début ou en fin de procédé. Mais il est préférable de traiter l'autre face 2 dès le départ afin d'obtenir une meilleure qualité de passivation du fait qu'il sera difficile par la suite de réaliser un traitement à l'acide fluorhydrique sur un seul côté du silicium sans entreprendre un procédé long et coûteux de protection de la face 3.

Il sera donc important de bien faire attention à l'état de la surface de l'autre face 2 au cours du traitement de la face 3.

On réalise donc sur l'autre face 2 du substrat semi-conducteur 1 un premier dépôt d'une couche de passivation de surface 4 (visible sur la figure 1). Cette couche de passivation de surface 4 peut être par exemple une couche de silicium amorphe intrinsèque. La couche de passivation de surface 4 peut également être réalisée avec du silicium amorphe d'un certain type de conductivité. Cette couche de passivation de surface 4 s'étend sur toute la superficie de l'autre face 2 du substrat semi-conducteur 1. Ce dépôt peut par exemple être réalisé par une technique de dépôt chimique en phase vapeur assisté par plasma (connu sous la dénomination anglo-saxonne PECVD pour Plasma Enhanced Chemical Vapor Déposition).

Par-dessus cette couche de passivation de surface 4, on réalise une couche antiréflective 5 (visible sur la figure 1). Cette couche antiréflective 5 est, par exemple, du nitrure de silicium. Cette couche antiréflective 5 s'étend sur toute la surface de la couche de passivation de surface 4. Elle peut être déposée par exemple par une technique de dépôt chimique en phase vapeur à faible pression (connu sous la dénomination anglo-saxonne LPCVD pour Low Pressure Chemical Vapor Déposition), ou bien par PECVD.

Après ces deux opérations, on réalise la face arrière du dispositif semi-conducteur 100.

On réalise une première couche isolante 11 sur l'autre face 3 du substrat semi-conducteur 1. Elle s'étend sur toute la superficie de l'autre face 3 du substrat semi-conducteur 1. Cette première couche 11 va permettre d'isoler par la suite les régions de silicium amorphe de types de conductivité différents. Cette première couche isolante 11 peut être, par exemple, du nitrure de silicium. Elle peut également être réalisée avec de l'oxyde de silicium. Dans le cas d'une première couche isolante 11 en nitrure de silicium, on peut l'obtenir par LPCVD ou PECVD. Sinon, dans le cas d'une première couche isolante 11 en oxyde de silicium, sa réalisation peut s'effectuer par PECVD.

Au moins une première fenêtre 12 est ensuite gravée dans la première couche isolante 11, mettant à nu une partie du substrat semi-conducteur 1. Cette première fenêtre 12 peut être réalisée par gravure laser ou par application de pâte de sérigraphie capable de graver le matériau isolant de la première couche isolante 11.

On réalise ensuite un dépôt d'une première couche 13 de semi-conducteur amorphe dopé d'un premier type de conductivité. Ce semi-conducteur pourra par exemple être du silicium amorphe dopé N. Ce dépôt pourra par exemple être réalisé par PECVD. Dans le cas d'un dopage de type N, il pourra être réalisé par exemple avec du phosphore. Cette première couche 13 de semi-conducteur amorphe dopée N est graduellement dopée pour assurer un bon état d'interface avec le substrat semi-conducteur 1. Le dépôt de cette première couche 13 de semi-conducteur amorphe se fait à la fois dans la première fenêtre 12 et sur toute la surface de la première couche isolante 11.

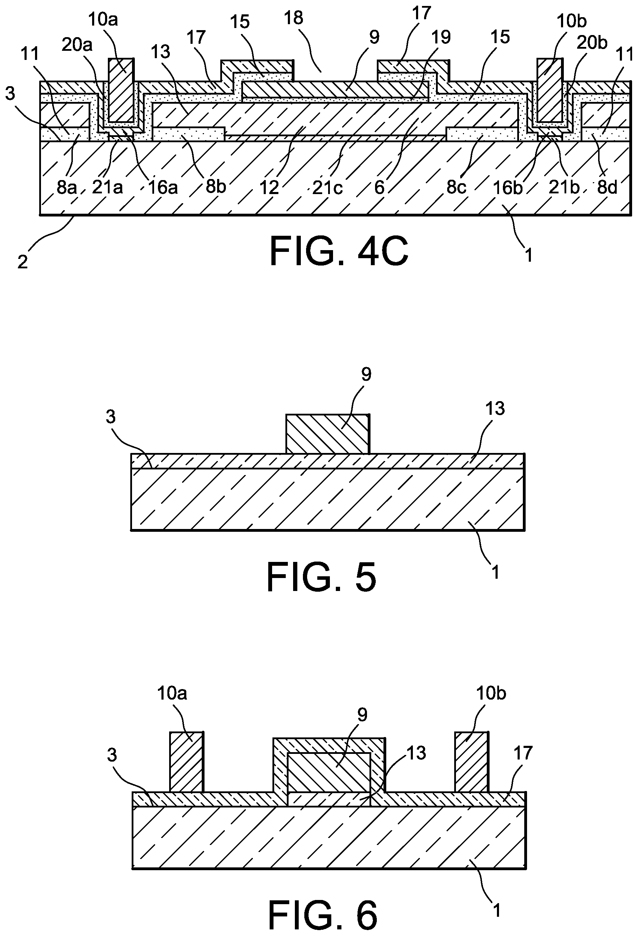

Il est également possible de réaliser, avant le dépôt de la première couche 13, un dépôt d'une première région de semi-conducteur intrinsèque 21c, représentée sur la figure 4C, dans la première fenêtre 12. On assure ainsi un bon état d'interface avec le substrat 1 en évitant les recombinaisons au niveau de la face 3 du substrat 1.

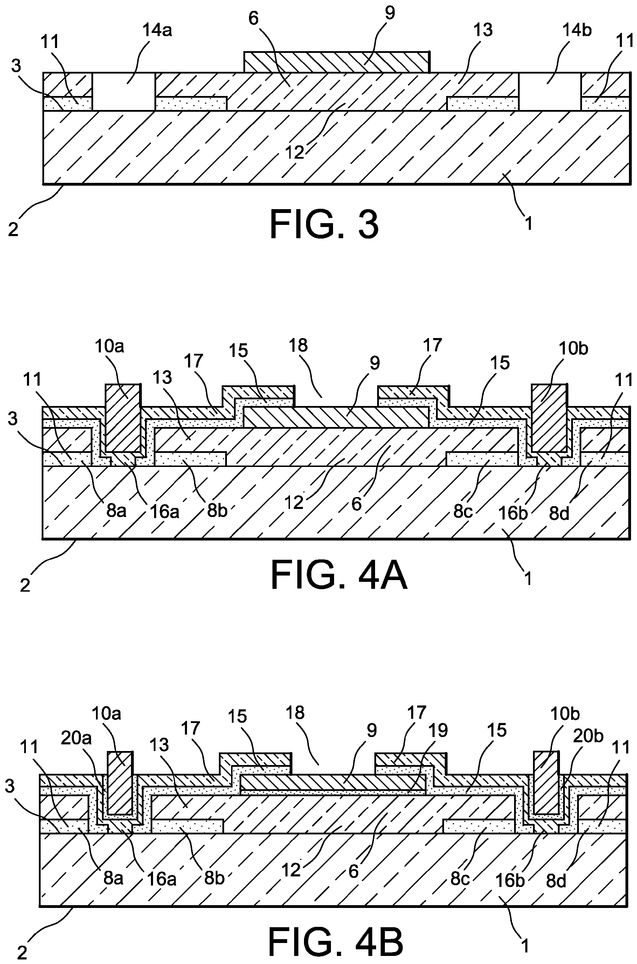

Comme on peut le voir sur la figure 3, on réalise alors le dépôt d'au moins une première zone de métallisation 9 sur la première couche 13 de semi-conducteur amorphe. Cette première zone de métallisation 9 peut être, par exemple, centrée au-dessus de la première fenêtre 12. Dans l'exemple illustré sur la figure 3, la première zone de métallisation 9 a une taille inférieure à celle de la première fenêtre 12 et est centrée au-dessus d'elle. L'épaisseur de cette première zone de métallisation 9 est de quelques dizaines de micromètres environ. Le dépôt de cette première zone de métallisation 9 peut être réalisé par évaporation, pulvérisation, sérigraphie de pâtes métalliques, ou encore par dépôt électrochimique. Cette première zone de métallisation 9 est réalisée, par exemple, à base d'un métal noble tel que l'argent, ou à base d'aluminium.

Au moins une seconde fenêtre 14a, 14b est ensuite gravée dans la première couche 13 de semi-conducteur amorphe et la première couche isolante 11. Dans l'exemple illustré sur la figure 3, deux secondes fenêtres 14a, 14b sont gravées dans la première couche 13 de semi-conducteur amorphe et la première couche isolante 11 de manière à mettre à nu une partie du substrat semi-conducteur 1. Ces secondes fenêtres 14a, 14b peuvent être réalisées par gravure laser ou par application de pâtes de sérigraphie capables de graver la couche de semi-conducteur amorphe 13 et la première couche isolante 11. Les secondes fenêtres 14a, 14b se trouvent décalées de part et d'autre de la première fenêtre 12. La gravure de ces deux secondes fenêtres 14a, 14b scinde en plusieurs parties la couche de semi-conducteur amorphe 13, délimitant ainsi au moins une première région 6 dopée du premier type de conductivité.

Lors de la réalisation du dispositif semi-conducteur 100, la gravure des secondes fenêtres 14a, 14b peut être faite avant le dépôt de la première zone de métallisation 9.

Comme on peut le voir sur la figure 4A, on réalise ensuite une seconde couche isolante 15. Cette seconde couche isolante 15 recouvre la première zone de métallisation 9, la première couche 13 de semi-conducteur amorphe, ainsi que les parties du substrat semi-conducteur 1 mis à nu par les secondes fenêtres 14a, 14b. Cette seconde couche isolante 15 peut être, par exemple, du nitrure de silicium. Elle peut également être réalisée par une couche d'oxyde de silicium. Dans le cas d'une seconde couche isolante 15 en nitrure de silicium, on peut l'obtenir par LPCVD ou PECVD. Enfin, dans le cas d'une seconde couche isolante 15 en oxyde de silicium, sa réalisation peut s'effectuer par PECVD.

On grave alors au moins une première ouverture 16a, 16b dans la seconde couche isolante 15, au niveau des deux secondes fenêtres 14a, 14b, mettant à nu une partie du substrat semi-conducteur 1. Dans l'exemple illustré sur la figure 4A, deux premières ouvertures 16a, 16b sont réalisées et chacune des deux premières ouvertures 16a, 16b a une superficie plus petite que leur seconde fenêtre respective 14a, 14b. Ces deux premières ouvertures 16a, 16b peuvent être réalisées par gravure laser ou par sérigraphie de pâtes gravantes. La gravure de ces deux premières ouvertures 16a, 16b scinde les couches isolantes 11 et 15 en plusieurs parties, délimitant ainsi les régions isolantes 8a, 8b, 8c, 8d.

On réalise ensuite le dépôt d'une seconde couche 17 de semi-conducteur amorphe dopée d'un second type de conductivité, opposé au premier type de conductivité. Ce semi-conducteur pourra donc par exemple être du silicium amorphe dopé P. Ce dépôt pourra par exemple être réalisé par PECVD. Dans le cas d'un dopage de type P, il pourra être réalisé par exemple avec du bore. Cette seconde couche 17 de semi-conducteur amorphe dopée P est graduellement dopée pour assurer un bon état d'interface avec le substrat semi-conducteur 1. Le dépôt de cette seconde couche 17 de semi-conducteur amorphe se fait à la fois dans les premières ouvertures 16a, 16b mais également sur toute la surface de la seconde couche isolante 15. La première couche 13 de semi-conducteur amorphe et la seconde couche 17 de semi-conducteur amorphe forme une structure inter-digitée, ayant un contour délimité lors de la gravure de la première fenêtre 12 et des premières ouvertures 16a, 16b.

Il est également possible de réaliser, avant le dépôt de la seconde couche 17, un dépôt de secondes régions de semi-conducteur intrinsèque 21a, 21b, représentées sur la figure 4C, dans les premières ouvertures 16a, 16b. Comme la région 21c, les régions de semi-conducteur intrinsèque 21a, 21b assurent un bon état d'interface avec le substrat 1 en évitant les recombinaisons au niveau de la face 3 du substrat 1.

On réalise ensuite le dépôt d'au moins une seconde zone de métallisation 10a, 10b sur la couche de semi-conducteur amorphe 17, dans les secondes fenêtres 14a, 14b, au moins au niveau des premières ouvertures 16a, 16b. Dans l'exemple illustré sur la figure 4A, deux secondes zones de métallisation 10a, 10b sont réalisées. Le dépôt de ces secondes zones de métallisation 10a, 10b peut être réalisé par évaporation, pulvérisation, sérigraphie de pâtes métalliques, ou encore par dépôt électrochimique. Ces secondes zones de métallisation 10a, 10b sont réalisées, par exemple, à base d'un métal noble tel que l'argent, ou à base d'aluminium.

Enfin, au moins une seconde ouverture 18 est gravée dans la seconde couche 17 de semi-conducteur amorphe et la seconde couche isolante 15, au dessus de la première zone de métallisation 9. Cette seconde ouverture 18 est réalisée pour accéder à la première zone de métallisation 9. On gravera de préférence une seconde ouverture 18 ayant une superficie plus petite que celle de la première zone de métallisation 9 et étant centrée au dessus de cette première zone de métallisation 9. Cette seconde ouverture 18 peut être réalisée par gravure laser ou par application de pâtes de sérigraphie capables de graver la seconde couche 17 de semi-conducteur amorphe et la seconde couche isolante 15.

En outre, dans l'ensemble des réalisations décrites, on pourra avantageusement prévoir d'intercaler entre les couches de silicium amorphe 13, 17 et les métallisations 9, 10a, 10b des zones 19, 20a, 20b d'oxyde thermique conducteur, comme cela est représenté sur les figures 4B et 4C. Ces zones 19, 20a, 20b d'oxyde thermique conducteur peuvent être par exemple en oxyde d'étain et d'indium ou en oxyde de zinc. Ces zones permettent d'assurer une meilleure résistivité de contact entre les métallisations 9, 10a, 10b et le semi-conducteur amorphe 13, 17.

Les figures 5, 6, 7A et 7B représentent les étapes d'un second procédé de réalisation d'un autre exemple de dispositif semi-conducteur 100, également objet de la présente invention. On suppose que le dispositif semi-conducteur 100 ainsi réalisé est une cellule solaire.

Ce procédé fait appel à un substrat semi-conducteur 1 identique à celui utilisé dans le premier procédé, objet de la présente invention. Comme pour le premier procédé, il est possible de décaper les faces 2 et 3 du substrat 1 par un nettoyage RCA classique et un nettoyage à l'acide fluorhydrique. Il est également possible de réaliser sur l'autre face 2 du substrat 1 une couche de passivation de surface 4 et une couche anti-réflective 5, visibles sur la figure 1.

Comme on peut le voir sur la figure 5, on réalise un dépôt d'une première couche 13 de semi-conducteur amorphe dopé d'un premier type de conductivité sur la face 3 du substrat 1. Ce semi-conducteur pourra par exemple être du silicium amorphe dopé N. Ce dépôt pourra par exemple être réalisé par PECVD. Dans le cas d'un dopage de type N, il pourra être réalisé par exemple avec du phosphore. Cette première couche 13 de semi-conducteur amorphe dopée N peut être graduellement dopée pour assurer un bon état d'interface avec le substrat semi-conducteur 1. Le dépôt de cette première couche 13 de semi-conducteur amorphe se fait sur toute la face 3 du substrat 1.

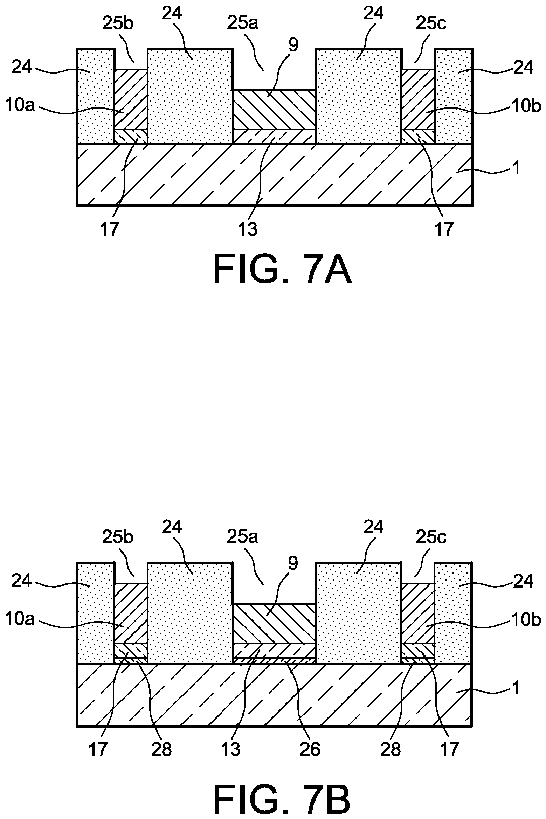

Il est également possible de réaliser, avant le dépôt de la première couche 13, un dépôt d'une première couche de semi-conducteur intrinsèque 26, représentée sur la figure 7B. On assure ainsi un bon état d'interface avec le substrat 1 en évitant les recombinaisons au niveau de la face 3 du substrat 1.

On réalise ensuite le dépôt d'au moins une première zone de métallisation 9 sur la première couche 13 de semi-conducteur amorphe. L'épaisseur de cette première zone de métallisation 9 est de quelques dizaines de micromètres environ. Le dépôt de cette première zone de métallisation 9 peut être réalisé par évaporation, pulvérisation, sérigraphie de pâtes métalliques, ou encore par dépôt électrochimique. Cette première zone de métallisation 9 est réalisée, par exemple, à base d'un métal noble tel que l'argent, ou à base d'aluminium.

On élimine alors des zones de la première couche 13 de semi-conducteur amorphe, et éventuellement de la couche de semi-conducteur intrinsèque 26, non recouvertes par la première zone de métallisation 9. Cette étape peut par exemple être réalisée par gravure sèche ou humide, ou encore par gravure sélective permettant de ne graver que le semi-conducteur amorphe et non le métal.

Comme on peut le voir sur la figure 6, on réalise ensuite le dépôt d'une seconde couche 17 de semi-conducteur amorphe dopée d'un second type de conductivité, opposé au premier type de conductivité. Ce semi-conducteur pourra donc par exemple être du silicium amorphe dopé P. Ce dépôt pourra par exemple être réalisé par PECVD. Dans le cas d'un dopage de type P, il pourra être réalisé par exemple avec du bore. Cette seconde couche 17 de semi-conducteur amorphe dopée P peut être graduellement dopée pour assurer un bon état d'interface avec le substrat semi-conducteur 1.

Là encore, il est également possible de réaliser, avant le dépôt de la seconde couche 17 de semi-conducteur amorphe, un dépôt d'une seconde couche de semi-conducteur intrinsèque 28, représentée sur la figure 7B.

On réalise ensuite le dépôt de secondes zones de métallisation 10a, 10b sur la couche de semi-conducteur amorphe 17. Dans l'exemple illustré sur la figure 6, deux secondes zones de métallisation 10a, 10b sont réalisées sur la seconde couche 17 de semi-conducteur amorphe. Le dépôt de ces secondes zones de métallisation 10a, 10b peut être réalisé par évaporation, pulvérisation, sérigraphie de pâtes métalliques, ou encore par dépôt électrochimique. Ces secondes zones de métallisation 10a, 10b sont réalisées, par exemple, à base d'un métal noble tel que l'argent, ou à base d'aluminium.

On élimine alors les zones de la seconde couche 17 de semi-conducteur amorphe, et éventuellement de la seconde couche de semi-conducteur intrinsèque 28, non recouvertes par les secondes zones de métallisation 10a, 10b. Cette étape peut par exemple être réalisée par gravure sèche ou humide ou par gravure sélective en ne gravant que le semi-conducteur et non le métal des métallisations 10a, 10b.

On dépose ensuite une couche isolante 24, par exemple de diélectrique, sur la face 3 du substrat 1 et sur les métallisations 9, 10a, 10b.

On réalise alors des ouvertures 25a, 25b, 25c dans la couche isolante 24, au niveau des métallisations 9, 10a, 10b. Ainsi, les métallisations 9, 10a, 10b deviennent accessibles depuis l'environnement extérieur.

En outre, dans l'ensemble des réalisations décrites, on pourra avantageusement prévoir d'intercaler entre les couches de silicium amorphe 13, 17 et les métallisations 9, 10a, 10b des zones 19, 20a, 20b d'oxyde thermique conducteur, comme cela est représenté sur les figures 4B et 4C. Ces zones 19, 20a, 20b d'oxyde thermique conducteur peuvent être par exemple en oxyde d'étain et d'indium ou en oxyde de zinc. Ces zones permettent d'assurer une meilleure résistivité de contact entre les métallisations 9, 10a, 10b et le semi-conducteur amorphe 13, 17.

Comme l'illustre la figure 5, plusieurs dispositifs semi-conducteurs 101 à 109, conformes à l'invention peuvent être réalisés en même temps sur le substrat semi-conducteur 1. Les dispositifs unitaires peuvent ensuite connectés entre eux par leurs zones de métallisation pour obtenir un module 200 de cellules solaires. Dans notre exemple illustré sur la figure 5, les dispositifs 101 à 103 sont connectés en série, de même que les dispositifs 104 à 106 et les dispositifs 107 à 109. Les trois groupes de cellules reliées en série ainsi formés sont connectés alors en parallèle.

Bien que plusieurs modes de réalisation de la présente invention aient été décrits de façon détaillée, on comprendra que différents changements et modifications puissent être apportés sans sortir du cadre de l'invention. Dans les exemples décrits, le premier type de conductivité est de type N et le second type P. Il est bien sûr possible que ce soit l'inverse, l'homme du métier n'ayant aucun problème pour choisir des matériaux appropriés conduisant à ces conductivités.

## Revendications

1. Dispositif semi-conducteur (100), comportant sur au moins une face (3) d'un substrat semi-conducteur (1) cristallin, au moins une première région (6) de semi-conducteur amorphe dopée par un premier type de conductivité, le substrat semi-conducteur (1) comportant sur la même face (3) au moins une seconde région (7a, 7b) de semi-conducteur amorphe dopée d'un second type de conductivité, opposé au premier type de conductivité, la première région (6) de semi-conducteur amorphe, isolée de la seconde région (7a, 7b) de semi-conducteur amorphe par au moins une région diélectrique (8a, 8b, 8c, 8d) en contact avec le substrat semi-conducteur (1) assurant également la passivation de la face (3) du substrat (1), et la seconde région (7a, 7b) de semi-conducteur amorphe formant une structure inter-digitée.

2. Dispositif semi-conducteur (100) selon la revendication 1, la région de diélectrique (8a, 8b, 8c, 8d) étant de l'oxyde de silicium ou du nitrure de silicium.

3. Dispositif semi-conducteur (100) selon l'une des revendications précédentes, au moins une première zone de métallisation (9) étant en contact avec la première région (6) de semi-conducteur amorphe et au moins une seconde zone de métallisation (10a, 10b) étant en contact avec la seconde région (7a, 7b) de semi-conducteur amorphe.

4. Dispositif semi-conducteur (100) selon la revendication 3, au moins une première zone d'oxyde thermique conducteur (19) se trouvant entre la première zone de métallisation (9) et la première région (6) de semi-conducteur amorphe et au moins une seconde zone d'oxyde thermique conducteur (20a, 20b) se trouvant entre la seconde zone de métallisation (10a, 10b) et la seconde région (7a, 7b) de semi-conducteur amorphe.

5. Dispositif semi-conducteur (100) selon la revendication 4, les zones d'oxyde thermique conducteur (19, 20a, 20b) étant en oxyde d'étain et d'indium ou en oxyde de zinc.

6. Dispositif semi-conducteur (100) selon l'une des revendications 3 à 5, les zones de métallisation (9, 10a, 10b) étant réalisées à base d'un métal noble, ou à base d'aluminium.

7. Dispositif semi-conducteur (100) selon l'une des revendications précédentes, le substrat semi-conducteur (1) comportant sur une autre face (2), opposée à la face (3) ayant la structure inter-digitée, une couche de passivation de surface (4) recouverte d'une couche antiréflective (5).

8. Dispositif semi-conducteur (100) selon la revendication 7, la couche de passivation de surface (4) étant en semi-conducteur amorphe intrinsèque, du premier type de conductivité ou du second type de conductivité.

9. Dispositif semi-conducteur (100) selon la revendication 8, la couche de passivation de surface (4) étant en silicium.

10. Dispositif semi-conducteur (100) selon l'une des revendications 7 à 9, la couche anti-réflective (5) étant en nitrure de silicium.

11. Dispositif semi-conducteur (100) selon l'une des revendications précédentes, le substrat semi-conducteur (1) étant en silicium monocristallin ou en silicium polycristallin.

12. Dispositif semi-conducteur (100) selon l'une des revendications précédentes, les régions (6, 7a, 7b) de semi-conducteur amorphe étant en silicium.

13. Dispositif semi-conducteur (100) selon l'une des revendications précédentes, le substrat semi-conducteur (1) étant d'un certain type de conductivité.

14. Dispositif semi-conducteur (100) selon l'une des revendications précédentes, le substrat semi-conducteur (1) étant un substrat en couche mince.

15. Dispositif semi-conducteur (100) selon l'une des revendications précédentes, des régions de semi-conducteur intrinsèque (21a, 21b, 21c) étant disposées entre les régions de semi-conducteur amorphe (6, 7a, 7b) et le substrat (1).

16. Dispositif semi-conducteur (100) selon l'une des revendications précédentes, ce dispositif semi-conducteur (100) étant une cellule solaire.

17. Module (200) de cellules solaires, comportant plusieurs cellules solaires (101 à 109) selon la revendication 16, connectées en série et/ou parallèle.

18. Procédé de réalisation d'un dispositif semi-conducteur (100) tel que revendiqué à la revendication 1, comportant les étapes suivantes :
a) réalisation sur une face (3) d'un substrat semi-conducteur (1) d'une première couche isolante (11),
b) gravure dans la première couche isolante (11) d'au moins une première fenêtre (12) mettant à nu une partie du substrat semi-conducteur (1),
c) dépôt d'une première couche (13) de semi-conducteur amorphe dopé d'un premier type de conductivité sur la première couche isolante (11) et dans la première fenêtre (12),
d) gravure dans la première couche (13) de semi-conducteur amorphe et la première couche isolante (11) d'au moins une seconde fenêtre (14a, 14b) décalée par rapport à la première fenêtre (12), mettant à nu une partie du substrat semi-conducteur (1),
e) réalisation d'une seconde couche isolante (15) dans la seconde fenêtre (14a, 14b) et sur la première couche (13) de semi-conducteur amorphe
f) gravure d'au moins une première ouverture (16a, 16b) dans la seconde couche isolante (15), au niveau de la seconde fenêtre (14a, 14b), mettant à nu une partie du substrat semi-conducteur (1),
g) dépôt d'une seconde couche (17) de semi-conducteur amorphe dopé d'un second type de conductivité opposé au premier type de conductivité dans la première ouverture (16a, 16b) et sur la seconde couche isolante (15),
la première couche (13) de semi-conducteur amorphe et la seconde couche (17) de semi-conducteur amorphe formant une structure inter-digitée ayant un contour délimité lors de la gravure de la première fenêtre (12) et de la première ouverture (16a, 16b).

19. Procédé selon la revendication 18, comportant entre l'étape b) et l'étape c), une étape de dépôt d'au moins une première région de semi-conducteur intrinsèque (21c) au moins dans la première fenêtre (12) et/ou, entre l'étape f) et l'étape g), une étape de dépôt d'au moins une seconde région de semi-conducteur intrinsèque (21a, 21b) au moins dans la première ouverture (16a, 16b).

20. Procédé selon l'une des revendications 18 ou 19, comportant entre l'étape c) et l'étape d), ou entre l'étape d) et l'étape e), une étape de dépôt d'au moins une première zone de métallisation (9) sur la première couche (13) de semi-conducteur amorphe.

21. Procédé selon l'une des revendications 18 ou 19, comportant entre l'étape c) et l'étape d), ou entre l'étape d) et l'étape e), une étape de dépôt d'au moins une première zone d'oxyde thermique conducteur (19) sur la première couche (13) de semi-conducteur amorphe, puis une étape de dépôt d'au moins une première zone de métallisation (9) sur la première zone d'oxyde thermique conducteur (19).

22. Procédé selon l'une des revendications 20 ou 21, la première zone de métallisation (9) étant centrée au-dessus de la première fenêtre (12).

23. Procédé selon l'une des revendications 20 à 22, la taille de la première zone de métallisation (9) étant inférieure à celle de la première fenêtre (12).

24. Procédé selon l'une des revendications 20 à 23, comportant après l'étape g) une étape de gravure d'au moins une seconde ouverture (18) dans la seconde couche (17) de semi-conducteur amorphe et dans la seconde couche isolante (15), au-dessus de la première zone de métallisation (9), dont la taille est inférieure ou égale à celle de la première zone de métallisation (9), mettant à nu au moins une partie de la première zone de métallisation (9).

25. Procédé selon l'une des revendications 20 à 24, comportant après l'étape g) une étape de dépôt d'au moins une seconde zone de métallisation (10a, 10b) sur la seconde couche (17) de semi-conducteur amorphe, au niveau de la seconde fenêtre (14a, 14b), sur au moins la première ouverture (16a, 16b).

26. Procédé selon l'une des revendications 20 à 25, comportant après l'étape g) une étape de dépôt d'au moins une seconde zone d'oxyde thermique conducteur (20a, 20b) sur la seconde couche (17) de semi-conducteur amorphe, au niveau de la seconde fenêtre (14a, 14b), sur au moins la première ouverture (16a, 16b), puis une étape de dépôt d'au moins une seconde zone de métallisation (10a, 10b) sur la seconde zone d'oxyde thermique conducteur (20a, 20b).

27. Procédé selon l'une des revendications 18 à 26, la première ouverture (16a, 16b) ayant une taille inférieure à celle de la seconde fenêtre (14a, 14b).

28. Procédé de réalisation d'un dispositif semi-conducteur (100) tel que revendiqué à la revendication 1, comportant les étapes suivantes :
a) dépôt sur une face (3) d'un substrat semi-conducteur (1) d'au moins une première couche (13) de semi-conducteur amorphe dopé d'un premier type de conductivité,
b) dépôt d'au moins une première zone de métallisation (9) sur au moins la première couche (13) de semi-conducteur amorphe,
c) élimination de zones de la première couche (13) de semi-conducteur amorphe non recouvertes par la première zone de métallisation (9),
d) dépôt d'au moins une seconde couche (17) de semi-conducteur amorphe dopé d'un second type de conductivité opposé au premier type de conductivité sur au moins la face (3) du substrat (1),
e) dépôt d'au moins une seconde zone de métallisation (10a, 10b) sur au moins la seconde couche (17) de semi-conducteur amorphe,
f) élimination de zones de la seconde couche (17) de semi-conducteur amorphe non recouvertes par la seconde zone de métallisation (10a, 10b),
g) dépôt d'une couche isolante (24) diélectrique sur au moins la face (3) du substrat (1), assurant également la passivation de la face (3) du substrat (1),
la première couche (13) de semi-conducteur amorphe et la seconde couche (17) de semi-conducteur amorphe formant une structure inter-digitée.

29. Procédé selon la revendication 28, comportant après l'étape g) de dépôt de la couche isolante (24), une étape de réalisation d'ouvertures (25a, 25b, 25c) dans la couche isolante (24) au niveau des zones de métallisation (9, 10a, 10b).

30. Procédé selon l'une des revendications 28 ou 29, comportant avant l'étape a) une étape de dépôt d'au moins une couche de semi-conducteur intrinsèque (26) sur la face (3) du substrat (1), la première couche (13) de semi-conducteur amorphe étant alors déposée sur la couche de semi-conducteur intrinsèque (26) et l'étape c) réalisant également l'élimination de zones de la couche de semi-conducteur intrinsèque (26) non recouvertes par la première zone de métallisation (9).

31. Procédé selon la revendication 30, comportant entre l'étape c) et l'étape d) une étape de dépôt d'au moins une seconde couche de semi-conducteur intrinsèque (28) sur au moins la face (3) du substrat (1), la seconde couche (17) de semi-conducteur amorphe étant alors déposée sur la seconde couche de semi-conducteur intrinsèque (28) et l'étape f) réalisant également l'élimination de zones de la seconde couche de semi-conducteur intrinsèque (28) non recouvertes par la seconde zone de métallisation (10a, 10b).

32. Procédé selon l'une des revendications 28 à 31, au moins l'une des étapes c) et/ou f) d'élimination de zones de semi-conducteur étant réalisée par gravure.

33. Procédé selon l'une quelconque des revendications 18 à 32, comportant les étapes suivantes :
- dépôt sur une autre face (2), opposée à la face (3) ayant la structure inter-digitée, du substrat semi-conducteur (1) d'une couche de passivation de surface (4),
- dépôt sur la couche de passivation de surface (4) d'une couche antiréflective (5).

34. Procédé selon la revendication 33, les étapes de dépôts de la couche de passivation de surface (4) et de la couche antiréflective (5) étant réalisées avant l'étape a).

35. Procédé selon l'une des revendications 18 à 34, au moins une gravure est réalisée par laser ou par sérigraphie de pâtes gravantes.

36. Procédé selon l'une des revendications 18 à 35, au moins une gravure étant une gravure sélective permettant de graver le semi-conducteur amorphe et non le métal.

37. Procédé selon l'une des revendications 18 à 36, le substrat semi-conducteur (1) étant préalablement décapé avec un nettoyage RCA classique et un nettoyage à l'acide fluorhydrique avant l'étape a).

## Patentansprüche

1. Halbleitervorrichtung (100), umfassend auf wenigstens einer Fläche (3) eines kristallinen Halbleitersubstrats (1) wenigstens eine erste amorphe Halbleiterregion (6), die mit einem ersten Leitfähigkeitstyp dotiert ist, wobei das Halbleitersubstrat (1) auf der gleichen Fläche (3) wenigstens eine zweite amorphe Halbleiterregion (7a, 7b) umfasst, die mit einem zweiten Leitfähigkeitstyp dotiert ist, der dem ersten Leitfähigkeitstyp entgegengesetzt ist, wobei die erste amorphe Halbleiterregion (6), die von der zweiten amorphen Halbleiterregion (7a, 7b) durch wenigstens eine dielektrische Region (8a, 8b, 8c, 8d) in Kontakt mit dem Halbleitersubstrat (1) isoliert ist, wodurch ferner die Passivierung der Fläche (3) des Substrats (1) gewährleistet ist, und die zweite amorphe Halbleiterregion (7a, 7b) eine Interdigitalstruktur bilden.

2. Halbleitervorrichtung (100) nach Anspruch 1, wobei die Dielektrikumsregion (8a, 8b, 8c, 8d) Siliziumoxid oder Siliziumnitrid ist.

3. Halbleitervorrichtung (100) nach einem der vorhergehenden Ansprüche, wobei wenigstens eine erste Metallisierungszone (9) in Kontakt mit der ersten amorphen Halbleiterregion (6) ist, und wenigstens eine zweite Metallisierungszone (10a, 10b) in Kontakt mit der zweiten amorphen Halbleiterregion (7a, 7b) ist.

4. Halbleitervorrichtung (100) nach Anspruch 3, wobei sich wenigstens eine erste thermisch leitende Oxidzone (19) zwischen der ersten Metallisierungszone (9) und der ersten amorphen Halbleiterregion (6) befindet, und sich wenigstens eine zweite thermisch leitende Oxidzone (20a, 20b) zwischen der zweiten Metallisierungszone (10a, 10b) und der zweiten amorphen Halbleiterregion (7a, 7b) befindet.

5. Halbleitervorrichtung (100) nach Anspruch 4, wobei die thermisch leitenden Oxidzonen (19, 20a, 20b) aus Zinn- und Indiumoxid oder aus Zinkoxid sind.

6. Halbleitervorrichtung (100) nach einem der Ansprüche 3 bis 5, wobei die Metallisierungszonen (9, 10a, 10b) auf Basis eines Edelmetalls oder auf Basis von Aluminium hergestellt sind.

7. Halbleitervorrichtung (100) nach einem der vorhergehenden Ansprüche, wobei das Halbleitersubstrat (1) auf einer anderen Fläche (2), die der Fläche (3) mit der Interdigitalstruktur entgegengesetzt ist, eine Oberflächenpassivierungsschicht (4) aufweist, die mit einer Antireflexionsschicht (5) bedeckt ist.

8. Halbleitervorrichtung (100) nach Anspruch 7, wobei die Oberflächenpassivierungsschicht (4) aus amorphem intrinsischem Halbleiter vom ersten Leitfähigkeitstyp oder vom zweiten Leitfähigkeitstyp ist.

9. Halbleitervorrichtung (100) nach Anspruch 8, wobei die Oberflächenpassivierungsschicht (4) aus Silizium ist.

10. Halbleitervorrichtung (100) nach einem der Ansprüche 7 bis 9, wobei die Antireflexionsschicht (5) aus Siliziumnitrid ist.

11. Halbleitervorrichtung (100) nach einem der vorhergehenden Ansprüche, wobei das Halbleitersubstrat (1) aus monokristallinem Silizium oder aus polykristallinem Silizium ist.

12. Halbleitervorrichtung (100) nach einem der vorhergehenden Ansprüche, wobei die amorphen Halbleiterregionen (6, 7a, 7b) aus Silizium sind.

13. Halbleitervorrichtung (100) nach einem der vorhergehenden Ansprüche, wobei das Halbleitersubstrat (1) von einem bestimmten Leitfähigkeitstyp ist.

14. Halbleitervorrichtung (100) nach einem der vorhergehenden Ansprüche, wobei das Halbleitersubstrat (1) ein Dünnschichtsubstrat ist.

15. Halbleitervorrichtung (100) nach einem der vorhergehenden Ansprüche, wobei intrinsische Halbleiterregionen (21a, 21b, 21c) zwischen den amorphen Halbleiterregionen (6, 7a, 7b) und dem Substrat (1) angeordnet sind.

16. Halbleitervorrichtung (100) nach einem der vorhergehenden Ansprüche, wobei diese Halbleitervorrichtung (100) eine Solarzelle ist.

17. Solarzellenmodul (200), umfassend mehrere Solarzellen (101 bis 109) nach Anspruch 16, die in Reihe und/oder parallel angeschlossen sind.

18. Verfahren zur Herstellung einer Halbleitervorrichtung (100) wie in Anspruch 1 beansprucht, umfassend die folgenden Schritte:
a) Herstellen einer ersten isolierenden Schicht (11) auf einer Fläche (3) eines Halbleitersubstrats (1),
b) Gravieren wenigstens eines ersten Fensters (12), das einen Teil des Halbleitersubstrats (1) freilegt, in die erste isolierende Schicht (11),
c) Aufbringen einer ersten amorphen Halbleiterschicht (13), die mit einem ersten Leitfähigkeitstyp dotiert ist, auf die erste isolierende Schicht (11) und in das erste Fenster (12),
d) Gravieren wenigstens eines zweiten Fensters (14a, 14b), das bezüglich des ersten Fensters (12) versetzt ist, in die erste amorphe Halbleiterschicht (13) und die erste isolierende Schicht (11), wodurch ein Teil des Halbleitersubstrats (1) freigelegt wird,
e) Herstellen einer zweiten isolierenden Schicht (15) in dem zweiten Fenster (14a, 14b) und auf der ersten amorphen Halbleiterschicht (13),
f) Gravieren wenigstens einer ersten Öffnung (16a, 16b) in die zweite isolierende Schicht (15) im Bereich des zweiten Fensters (14a, 14b), wodurch ein Teil des Halbleitersubstrats (1) freigelegt wird,
g) Aufbringen einer zweiten amorphen Halbleiterschicht (17), die mit einem zweiten Leitfähigkeitstyp dotiert ist, der dem ersten Leitfähigkeitstyp entgegengesetzt ist, in die erste Öffnung (16a, 16b) und auf die zweite isolierende Schicht (15),
wobei die erste amorphe Halbleiterschicht (13) und die zweite amorphe Halbleiterschicht (17) eine Interdigitalstruktur mit einem Umfang bilden, der während des Gravierens des ersten Fensters (12) und der ersten Öffnung (16a, 16b) begrenzt wird.

19. Verfahren nach Anspruch 18, umfassend zwischen dem Schritt b) und dem Schritt c) einen Schritt des Aufbringens wenigstens einer ersten intrinsischen Halbleiterregion (21c) wenigstens in dem ersten Fenster (12) und/oder, zwischen dem Schritt f) und dem Schritt g), einen Schritt des Aufbringens wenigstens einer zweiten intrinsischen Halbleiterregion (21a, 21b) wenigstens in der ersten Öffnung (16a, 16b).

20. Verfahren nach einem der Ansprüche 18 oder 19, umfassend zwischen dem Schritt c) und dem Schritt d) oder dem Schritt d) und dem Schritt e) einen Schritt des Aufbringens wenigstens einer ersten Metallisierungszone (9) auf die erste amorphe Halbleiterschicht (13).

21. Verfahren nach einem der Ansprüche 18 oder 19, umfassend zwischen dem Schritt c) und dem Schritt d) oder dem Schritt d) und dem Schritt e) einen Schritt des Aufbringens wenigstens einer ersten thermisch leitenden Oxidzone (19) auf die erste amorphe Halbleiterschicht (13) und anschließend einen Schritt des Aufbringens wenigstens einer ersten Metallisierungszone (9) auf die erste thermisch leitende Oxidzone (19).

22. Verfahren nach einem der Ansprüche 20 oder 21, wobei die erste Metallisierungszone (9) über dem ersten Fenster (12) zentriert wird.

23. Verfahren nach einem der Ansprüche 20 bis 22, wobei die Größe der ersten Metallisierungszone (9) kleiner ist als jene des ersten Fensters (12).

24. Verfahren nach einem der Ansprüche 20 bis 23, umfassend nach dem Schritt g) einen Schritt des Gravierens wenigstens einer zweiten Öffnung (18) in die zweite amorphe Halbleiterschicht (17) und in die zweite isolierende Schicht (15) über der ersten Metallisierungszone (9), deren Größe kleiner oder gleich jener der ersten Metallisierungszone (9) ist, wodurch wenigstens ein Teil der ersten Metallisierungszone (9) freigelegt wird.

25. Verfahren nach einem der Ansprüche 20 bis 24, umfassend nach dem Schritt g) einen Schritt des Aufbringens wenigstens einer zweiten Metallisierungszone (10a, 10b) auf der zweiten amorphen Halbleiterschicht (17) im Bereich des zweiten Fensters (14a, 14b) wenigstens auf der ersten Öffnung (16a, 16b).

26. Verfahren nach einem der Ansprüche 20 bis 25, umfassend nach dem Schritt g) einen Schritt des Aufbringens wenigstens einer zweiten thermisch leitenden Oxidzone (20a, 20b) auf die zweite amorphe Halbleiterschicht (17) im Bereich des zweiten Fensters (14a, 14b) wenigstens auf der ersten Öffnung (16a, 16b) und anschließend einen Schritt des Aufbringens wenigstens einer zweiten Metallisierungszone (10a, 10b) auf die zweite thermisch leitende Oxidzone (20a, 20b).

27. Verfahren nach einem der Ansprüche 18 bis 26, wobei die erste Öffnung (16a, 16b) eine Größe kleiner als jene des zweiten Fensters (14a, 14b) hat.

28. Verfahren zur Herstellung einer Halbleitervorrichtung (100) wie in Anspruch 1 beansprucht, umfassend die folgenden Schritte:
a) Aufbringen wenigstens einer ersten amorphen Halbleiterschicht (13), die mit einem ersten Leitfähigkeitstyp dotiert ist, auf einer Fläche (3) eines Halbleitersubstrats (1),
b) Aufbringen wenigstens einer ersten Metallisierungszone (9) wenigstens auf die erste amorphe Halbleiterschicht (13),
c) Beseitigen von Zonen der ersten amorphen Halbleiterschicht (13), die nicht durch die erste Metallisierungszone (9) bedeckt sind,
d) Aufbringen wenigstens einer zweiten amorphen Halbleiterschicht (17), die mit einem zweiten Leitfähigkeitstyp dotiert ist, der dem ersten Leitfähigkeitstyp entgegengesetzt ist, wenigstens auf die Fläche (3) des Substrats (1),
e) Aufbringen wenigstens einer zweiten Metallisierungszone (10a, 10b) wenigstens auf die zweite amorphe Halbleiterschicht (17),
f) Entfernen von Zonen der zweiten amorphen Halbleiterschicht (17), die nicht durch die zweite Metallisierungszone (10a, 10b) bedeckt sind,
g) Aufbringen einer dielektrischen isolierenden Schicht (24) wenigstens auf die Fläche (3) des Substrats (1), wodurch ferner die Passivierung der Fläche (3) des Substrats (1) gewährleistet wird,
wobei die erste amorphe Halbleiterschicht (13) und die zweite amorphe Halbleiterschicht (17) eine Interdigitalstruktur bilden.

29. Verfahren nach Anspruch 28, umfassend nach dem Schritt g) des Aufbringens der isolierenden Schicht (24) einen Schritt der Herstellung von Öffnungen (25a, 25b, 25c) in der isolierenden Schicht (24) im Bereich der Metallisierungszonen (9, 10a, 10b).

30. Verfahren nach einem der Ansprüche 28 oder 29, umfassend vor dem Schritt a) einen Schritt des Aufbringens wenigstens einer intrinsischen Halbleiterschicht (26) auf die Fläche (3) des Substrats (1), wobei die erste amorphe Halbleiterschicht (13) dann auf die intrinsische Halbleiterschicht (26) aufgebracht wird, und im Schritt c) ferner das Entfernen von Zonen der intrinsischen Halbleiterschicht (26) realisiert wird, die nicht durch die erste Metallisierungszone (9) bedeckt sind.

31. Verfahren nach Anspruch 30, umfassend zwischen dem Schritt c) und dem Schritt d) einen Schritt des Aufbringens wenigstens einer zweiten intrinsischen Halbleiterschicht (28) wenigstens auf die Fläche (3) des Substrats (1), wobei die zweite amorphe Halbleiterschicht (17) dann auf die zweite intrinsische Halbleiterschicht (28) aufgebracht wird, und im Schritt f) ferner das Entfernen von Zonen der zweiten intrinsischen Halbleiterschicht (28) realisiert wird, die nicht durch die zweite Metallisierungszone (10a, 10b) bedeckt sind.

32. Verfahren nach einem der Ansprüche 28 bis 31, wobei wenigstens einer der Schritte c) und/oder f) des Entfernens von Halbleiterzonen durch Gravieren realisiert wird.

33. Verfahren nach einem der Ansprüche 18 bis 32, umfassend die folgenden Schritte:
- Aufbringen einer Oberflächenpassivierungsschicht (4) auf eine andere Fläche (2) des Halbleitersubstrats (1), die der Fläche (3) entgegengesetzt ist, die die Interdigitalstruktur hat,
- Aufbringen einer Antireflexionsschicht (5) auf die Oberflächenpassivierungsschicht (4).

34. Verfahren nach Anspruch 33, wobei die Schritte des Aufbringens der Oberflächenpassivierungsschicht (4) und der Antireflexionsschicht (5) vor dem Schritt a) ausgeführt werden.

35. Verfahren nach einem der Ansprüche 18 bis 34, wobei wenigstens eine Gravur durch Laser oder durch Graviermassenserigraphie realisiert wird.

36. Verfahren nach einem der Ansprüche 18 bis 35, wobei wenigstens eine Gravur eine selektive Gravur ist, die es erlaubt, den amorphen Halbleiter und nicht das Metall zu gravieren.

37. Verfahren nach einem der Ansprüche 18 bis 36, wobei das Halbleitersubstrat (1) zuvor mit einer klassischen RCA-Reinigung und einer Fluorwasserstoffsäurereinigung vor dem Schritt a) dekapiert wird.

## Claims

1. Semiconductor device (100) comprising, on at least one face (3) of a crystalline semiconductor substrate (1), at least one first amorphous semiconductor region (6) doped with a first type of conductivity, which semiconductor substrate (1) comprising, on the same face (3), at least one second amorphous semiconductor region (7a, 7b) doped with a second type of conductivity, opposite the first type of conductivity, the first amorphous semiconductor region (6), insulated from the second amorphous semiconductor region (7a, 7b) by at least one dielectric region (8a, 8b, 8c, 8d) in contact with the semiconductor substrate (1) also ensuring the passivation of the face (3) of the substrate (1), and the second amorphous semiconductor region (7a, 7b), forming an interdigitated structure.

2. Semiconductor device (100) according to claim 1, the dielectric region (8a, 8b, 8c, 8d) being made of silicon oxide or silicon nitride.

3. Semiconductor device (100) according to any one of the previous claims, at least one first metallization area (9) being in contact with the first amorphous semiconductor region (6), and at least one second metallization area (10a, 10b) being in contact with the second amorphous semiconductor region (7a, 7b).

4. Semiconductor device (100) according to claim 3, at least one first conductive thermal oxide area (19) being located between the first metallization area (9) and the first amorphous semiconductor region (6) and at least one second conductive thermal oxide area (20a, 20b) being located between the second metallization area (10a, 10b) and the second amorphous semiconductor region (7a, 7b).

5. Semiconductor device (100) according to claim 4, the conductive thermal oxide areas (19, 20a, 20b) being made of indium and tin oxide or zinc oxide.

6. Semiconductor device (100) according to any one of claims 3 to 5, the metallization areas (9, 10a, 10b) being based on a noble metal, or based on aluminium.

7. Semiconductor device (100) according to any one of the previous claims, the semiconductor substrate (1) comprising, on another face (2), opposite the face (3) having the interdigitated structure, a surface passivation layer (4) coated with an antireflective layer (5).

8. Semiconductor device (100) according to claim 7, the surface passivation layer (4) being made of an intrinsic amorphous semiconductor with the first type of conductivity or the second type of conductivity.

9. Semiconductor device (100) according to claim 8, the surface passivation layer (4) being made of silicon.

10. Semiconductor device (100) according to any one of claims 7 to 9, the antireflective layer (5) being made of silicon nitride.

11. Semiconductor device (100) according to any one of the previous claims, the semiconductor substrate (1) being made of monocrystalline silicon or polycrystalline silicon.

12. Semiconductor device (100) according to any one of the previous claims, the amorphous semiconductor regions (6, 7a, 7b) being made of silicon.

13. Semiconductor device (100) according to any one of the previous claims, the semiconductor substrate (1) being of a certain type of conductivity.

14. Semiconductor device (100) according to any one of the previous claims, the semiconductor substrate (1) being a thin-layer substrate.

15. Semiconductor device (100) according to any one of the previous claims, intrinsic semiconductor regions (21a, 21b, 21c) being arranged between the amorphous semiconductor regions (6, 7a, 7b) and the substrate (1).

16. Semiconductor device (100) according to any one of the previous claims, said semiconductor device (100) being a solar cell.

17. Module (200) of solar cells, comprising a plurality of solar cells (101 to 109) according to claim 16, connected in series and/or in parallel.

18. Method for producing a semiconductor device (100) as claimed in claim 1, comprising the following steps:
a) producing a first insulating layer (11) on a face (3) of a semiconductor substrate (1);
b) etching, in the first insulating layer (11), at least one first window (12) exposing a portion of the semiconductor substrate (1);
c) depositing a first amorphous semiconductor layer (13) doped with a first type of conductivity on the first insulating layer (11) and in the first window (12);
d) etching, in the first amorphous semiconductor layer (13) and the first insulating layer (11), at least one second window (14a, 14b), offset from the first window (12), exposing a portion of the semiconductor substrate (1);
e) producing a second insulating layer (15) in the second window (14a, 14b) and on the first amorphous semiconductor layer (13);
f) etching at least one first opening (16a, 16b) in the second insulating layer (15), at the level of the second window (14a, 14b), exposing a portion of the semiconductor substrate (1);
g) depositing a second amorphous semiconductor layer (17) doped with a second type of conductivity opposite the first type of conductivity in the first opening (16a, 16b), and on the second insulating layer (15);
wherein the first amorphous semiconductor layer (13) and the second amorphous semiconductor layer (17) form an interdigitated structure having a contour defined by the etching of the first window (12) and the first opening (16a, 16b).

19. Method according to claim 18, comprising, between step b) and step c), a step of depositing at least one first intrinsic semiconductor region (21c) at least in the first window (12) and/or, between step f) and step g), a step of depositing at least one second intrinsic semiconductor region (21a, 21b) at least in the first opening (16a, 16b).

20. Method according to one of claims 18 or 19, comprising, between step c) and step d), or between step d) and step e), a step of depositing at least one first metallization area (9) on the first amorphous semiconductor layer (13).

21. Method according to one of claims 18 or 19, comprising, between step c) and step d), or between step d) and step e), a step of depositing at least one first conductive thermal oxide area (19) on the first amorphous semiconductor layer (13), then a step of depositing at least one first metallization area (9) on the first conductive thermal oxide area (19).

22. Method according to one of claims 20 or 21, the first metallization area (9) being centred above the first window (12).

23. Method according to one of claims 20 to 22, the size of the first metallization area (9) being smaller than that of the first window (12).

24. Method according to one of claims 20 to 23, comprising, after step g), a step of etching at least one second opening (18) in the second amorphous semiconductor layer (17) and in the second insulating layer (15), above the first metallization area (9), of which the size is smaller than or equal to that of the first metallization area (9), exposing at least a portion of the first metallization area (9).

25. Method according to one of claims 20 to 24, comprising, after step g), a step of depositing at least one second metallization area (10a, 10b) on the second amorphous semiconductor layer (17), at the level of the second window (14a, 14b), on at least the first opening (16a, 16b).

26. Method according to one of claims 20 to 25, comprising, after step g), a step of depositing at least one second conductive thermal oxide area (20a, 20b) on the second amorphous semiconductor layer (17), at the level of the second window (14a, 14b), on at least the first opening (16a, 16b), then a step of depositing at least one second metallization area (10a, 10b) on the second conductive thermal oxide area (20a, 20b).

27. Method according to one of claims 18 to 26, the first opening (16a, 16b) being smaller than the second window (14a, 14b).

28. Method for producing a semiconductor device (100) as claimed in claim 1, comprising the following steps:
a) depositing at least one first amorphous semiconductor layer (13) doped with a first type of conductivity on a face (3) of a semiconductor substrate (1) ;
b) depositing at least one first metallization area (9) on at least the first amorphous semiconductor layer (13);
c) removing areas of the first amorphous semiconductor layer (13) not covered by the first metallization area (9);
d) depositing at least one second amorphous semiconductor layer (17) doped with a second type of conductivity opposite the first type of conductivity on at least the face (3) of the substrate (1);
e) depositing at least one second metallization area (10a, 10b) on at least the second amorphous semiconductor layer (17);
f) removing areas of the second amorphous semiconductor layer (17) not covered by the second metallization area (10a, 10b),
g) depositing a dielectric insulating layer (24) on at least one face (3) of the substrate (1), also ensuring the passivation of the face (3) of the substrate (1);
wherein the first amorphous semiconductor layer (13) and the second amorphous semiconductor layer (17) form an interdigitated structure.

29. Method according to claim 28, comprising, after the step g) of depositing the insulating layer (24), a step of producing openings (25a, 25b, 25c) in the insulating layer (24) at the level of the metallization areas (9, 10a, 10b).

30. Method according to one of claims 28 or 29, comprising, before step a), a step of depositing at least one intrinsic semiconductor layer (26) on the face (3) of the substrate (1), the first amorphous semiconductor layer (13) being then deposited on the intrinsic semiconductor layer (26) and step c) also involving the removal of areas of the intrinsic semiconductor layer (26) not covered by the first metallization area (9).

31. Method according to claim 30, comprising, between step c) and step d), a step of depositing at least one second intrinsic semiconductor layer (28) on at least the face (3) of the substrate (1), the second amorphous semiconductor layer (17) being then deposited on the second intrinsic semiconductor layer (28) and step f) also involving the removal of areas of the second intrinsic semiconductor layer (28) not covered by the second metallization area (10a, 10b).

32. Method according to one of claims 28 to 31, at least one of steps c) and/or f) of removing semiconductor areas being performed by etching.

33. Method according to any one of claims 18 to 32, comprising the following steps:
- depositing the semiconductor substrate of a surface passivation layer (4) onto another face (2), opposite to the face (3) of the semi-conductor substrate (1) having the interdigitated structure;
- depositing an antireflective layer (5) on the surface passivation layer (4).

34. Method according to claim 33, the steps of depositing the surface passivation layer (4) and the antireflective layer (5) being performed before step a).

35. Method according to one of claims 18 to 34, at least one etching operation being performed by laser or by serigraphy with etching pastes.

36. Method according to one of claims 18 to 35, at least one etching operation being a selective etching operation making it possible to etch the amorphous semiconductor and not the metal.

37. Method according to one of claims 18 to 36, the semiconductor substrate (1) being first chemically cleaned by a conventional RCA cleaning and a hydrofluoric acid cleaning before step a).
